(19) **Europäisches Patentamt**
**European Patent Office**
**Office européen des brevets**

(11) **EP 1 726 419 B1**

(12) **EUROPEAN PATENT SPECIFICATION**

(45) Date of publication and mention
of the grant of the patent:
**04.05.2011 Bulletin 2011/18**

(21) Application number: **05721002.3**

(22) Date of filing: **17.03.2005**

(51) Int Cl.:
***B28B 3/22*** *(2006.01)* ***H01L 21/48*** *(2006.01)*

(86) International application number:
**PCT/JP2005/004815**

(87) International publication number:
**WO 2005/090032 (29.09.2005 Gazette 2005/39)**

(54) **PROCESS FOR PRODUCING A CERAMIC SHEET**

VERFAHREN ZUR HERSTELLUNG EINER KERAMIKPLATTE

PROCÉDÉ DE FABRICATION DE FEUILLE CÉRAMIQUE

(84) Designated Contracting States:
**CH DE GB LI**

(30) Priority: **19.03.2004 JP 2004079787**

(43) Date of publication of application:
**29.11.2006 Bulletin 2006/48**

(73) Proprietor: **DENKI KAGAKU KOGYO KABUSHIKI KAISHA**
**Tokyo 103-8338 (JP)**

(72) Inventors:
• **Terao, Ryou**
**c/o Denki Kagaku Kogyo KK**
**Omuta-shi, Fukuoka 8368510 (JP)**
• **Fukuda, Makoto,**
**c/o Denki Kagaku Kogyo KK**
**Omuta-shi, Fukuoka 8368510 (JP)**

• **Yoshino, Nobuyuki,**
**c/o Denki Kagaku Kogyo KK**
**Omuta-shi, Fukuoka 8368510 (JP)**

(74) Representative: **Hartz, Nikolai**
**Wächtershäuser & Hartz**
**Patentanwaltspartnerschaft**
**Weinstrasse 8**
**80333 München (DE)**

(56) References cited:
**EP-A- 1 450 401 WO-A-01/43931**
**JP-A- 5 220 803 JP-A- 7 205 147**
**JP-A- 2000 238 023 JP-A- 2002 079 509**
**JP-A- 2002 144 313 JP-A- 2006 103 277**
**US-A- 4 663 103**

EP 1 726 419 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a process for producing a ceramic sheet.

BACKGROUND ART

Heretofore, a circuit board has been one having an electrically conductive metal circuit joined to a main surface of a ceramic substrate on which a semiconductor is to be mounted by means of solder, and having a semiconductor device mounted on a predetermined position on the metal circuit. In order to maintain high reliability of a circuit board, it is required that heat generated from a semiconductor device is dissipated so that the temperature of the semiconductor device will not excessively high, and thus a ceramic substrate is required to have excellent heat dissipation properties in addition to electrical insulating properties. In recent years, along with miniaturizing of a circuit board and high output of a power module, for a small light-weight module, a ceramic substrate employing an aluminum nitride (hereinafter referred to as AlN) sintered body having high electrical insulating properties and high thermal conductivity and a ceramic circuit board having a metal circuit formed on a main surface of an AlN substrate have attracted attention.

A ceramic sintered body to be employed for a ceramic substrate is produced usually by the following process. Namely, a ceramic powder is mixed with additives such as a sintering aid, an organic binder, a plasticizer, a dispersant and a mold release agent in a suitable amount, and the mixture is molded into a thin plate or a sheet by extrusion or tape molding. Further, in the case of a thick plate shape or a large shape, molding is carried out by extrusion or pressing (in the present invention, a sheet having a thickness less than 1 mm will be referred to as a thin plate and a plate having a thickness of 1 mm or more will be referred to as a thick plate). Then, the molded product is heated in the air or in an inert gas atmosphere of e.g. nitrogen at from 450 to 650°C to remove the organic binder (debindering step) and held in a non-oxidizing atmosphere such as in nitrogen at from 1,600 to 1,900°C for from 0.5 to 10 hours (firing step) to produce a ceramic sintered body.

In general, by employing extrusion, the thickness in molding will not be limited any more and it is possible to mold a ceramic sheet in the form of either a thin plate or a thick plate. First, a powder mixture comprising a ceramic powder preliminarily treated with oleic acid, a sintering aid and an organic powder binder is prepared by using e.g. a universal mixer, an automatic mortar, a mixer or a vibrating sieve. The powder mixture is sprayed with a liquid mixture comprising e.g. water, an organic liquid binder, a mold release agent and a plasticizer to prepare a granular wet powder material (granulation step) by using e.g. a universal mixer, an automatic mortar, a mixer or a vibrating sieve. Then, in order that the AlN powder treated with oleic acid and the binder aqueous solution in the wet powder are blended, the wet powder is left at low temperature for from 2 to 3 days (aging step). This material is charged into a material feed opening of a kneader to prepare a kneaded clay (kneading step), which is further left to stand at low temperature for from 2 to 3 days to reduce the viscosity of the kneaded clay. The kneaded clay was charged into a material feed opening of a single screw extruder provided with a die and molded into a thick plate or a sheet (Patent Documents 1 and 2).

    Patent Document 1: JP-A-2-83265
    Patent Document 2: JP-A-11-21174

EP-A 0545056 discloses an extrusion method and apparatus for producing a body from powder material.

DISCLOSURE OF THE INVENTION

OBJECT TO BE ACCOMPLISHED BY THE INVENTION

The above conventional production process is a production process with a prolonged lead time requiring material granulation (granulation step) and homogenization of a kneaded clay (kneading and aging steps). Further, if the homogenization of the kneaded clay is insufficient, the dispersion of the density of a green sheet will occur, whereby a ceramic sintered body after firing will be deformed. The object of the present invention is to provide a process for producing a ceramic sheet, whereby a quality equivalent to or superior to that of the prior art can be obtained and high production efficiency can be attained, and a ceramic substrate utilizing it and its use.

MEANS TO ACCOMPLISH THE OBJECT

(1) A process for producing a ceramic sheet, which comprises molding a ceramic sheet having a thickness of from 1 to 10 mm by using an extrusion molding machine in which a discharge outlet of a twin screw extruder and a material feed opening of a single screw extruder are connected, and which further comprises (a) supplying a powder mixture comprising a ceramic powder, a sintering aid and an organic binder powder through a powder feed portion of the twin screw extruder, (b) supplying a liquid comprising a liquid organic binder, a mold release agent and a plasticizer through a liquid feed portion of the twin screw extruder, (c) kneading the powder mixture and the liquid in the kneading portion in the interior of the twin screw extruder having kneading portion and a carrier severs portion, and (d) molding a sheet from the single screw extruder equipped with a sheet die.

(2) The process for producing a ceramic sheet according to the above (1), wherein the connection portion of the discharge outlet of the twin screw extruder and the material feed opening of the single screw extruder is depressurized.

(3) The process for producing a ceramic sheet according to the above (2), wherein the degree of vacuum at the connection portion of the discharge outlet of the twin screw extruder and the material feed opening of the single screw extruder is at most 1332.2 Pa.

(4) The process for producing a ceramic sheet according to any one of the above (1) to (3), wherein the temperatures of products discharged from the twin screw extruder and the single screw extruder are from 5 to 15°C.

(5) The process for producing a ceramic sheet according to any one of the above (1) to (4), wherein a kneading portion of the twin screw extruder occupies from 30 to 70 vol% of the twin screw extruder.

(6) The process for producing a ceramic sheet according to the above (5), wherein the kneading portion of the twin screw extruder is made of an abrasive resistant material.

(7) The process for producing a ceramic sheet according to any one of the above (1) to (6), wherein a structure to hold the screw is provided at an intermediate portion and/or the tip of the screw in the twin screw extruder.

(8) The process for producing a ceramic sheet according to any one of the above (1) to (7), wherein a pressure-equalizing can having a length the same as or longer than its diameter is provided in the single screw extruder.

(9) The process for producing a ceramic sheet according to any one of the above (1) to (8), wherein a die having a flat portion with a length of at lest 5 mm is provided at a discharge outlet of the single screw extruder.

(10) The process for producing a ceramic sheet according to any one of the above (1) to (9), wherein a baffle board is provided between the die at the discharge outlet and the pressure-equalizing can in the single screw extruder.

(11) The process for producing a ceramic sheet according to the above (1), wherein the ceramic powder is a nitride ceramic, the sintering aid powder is a rare earth oxide, the organic binder powder is a cellulose or acrylic binder, and the liquid organic binder is an acrylic binder.

(12) The process for producing a ceramic sheet according to the above (11), wherein the nitride ceramic is aluminum nitride, and the sheet has an apparent density of at least 2.5 g/cm$^3$.

(13) The process for producing a ceramic sheet according to any one of the above (1) to (12), wherein the sheet strength is at least 1.47 MPa.

(14) A ceramic substrate obtained by applying debindering and sintering treatments to a ceramic sheet produced by the process as defined in any one of the above (1) to (13) is disclosed.

(15) The ceramic substrate according to the above (14), wherein the proportion of void is at most 3 vol % is disclosed.

(16) A ceramic circuit board for a module, which comprises a metal circuit formed on one main surface of the ceramic substrate as defined in the above (14) or (15) and a heatsink joined to the other main surface is disclosed.

(17) The ceramic circuit board for a module according to the above (16), wherein the 10 pC or higher partial discharge inception voltage is at least 5 kV is disclosed.

(18) A module comprising the ceramic circuit board as defined in the above (16) or (17) is also disclosed. (14) to (18) are not claimed.

EFFECTS OF THE INVENTION

According to the present invention, a process for producing a ceramic sheet, whereby a quality equivalent to or superior to that of the prior art can be obtained and high production efficiency can be attained, is provided, which is applicable to production of a ceramic substrate and a module.

BRIEF DESCRIPTION OF THE DRAWINGS

Fig. 1 illustrates one embodiment of an extrusion molding machine of the present invention.
Fig. 2 illustrates one embodiment of screws of a twin screw extruder and a single screw extruder of the present invention.
Fig. 3 illustrates one embodiment of an extrusion molding machine of the present invention.

Fig. 4 illustrates one embodiment of a ceramic circuit board of the present invention:

MEANING OF SYMBOLS

(Fig. 1)

1: Powder feed opening
2: Liquid feed opening
3: Twin screw extruder
4: Vent port
5: Strand die
6: Vacuum chamber
7: Kneader
8: Sheet die
9: Single screw extruder

(Fig. 2)

1: Kneading screw
2: Carrier screw

(Fig. 3)

1: Pressure-equalizing can
2: Baffle board
3: Molding die (with cooling function)
4: Die
5: Flat portion
6: Axis-holding screw

(Fig. 4)

1: Metal plate at the circuit side
2: Metal plate at the heatsink side
3: AlN substrate

BEST MODE FOR CARRYING OUT THE INVENTION

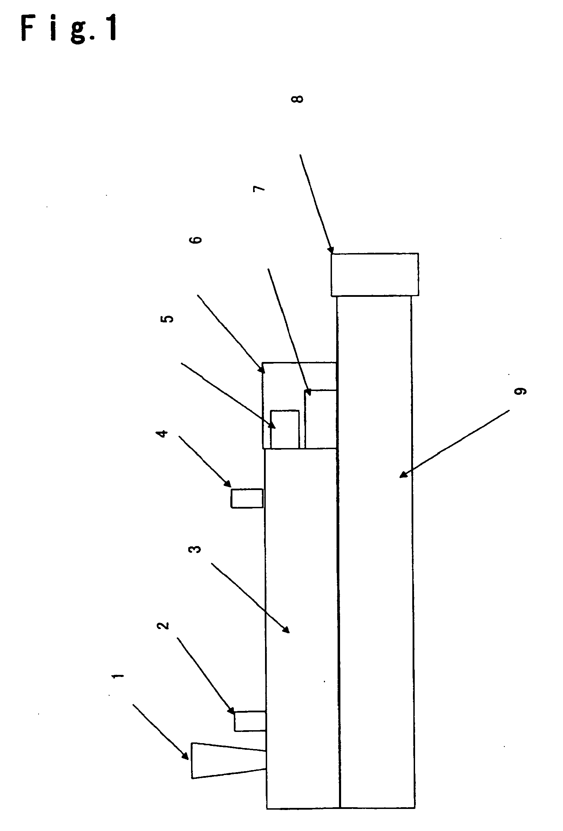

The present inventors have studied a doctor blade method, an extrusion method, a dry pressing method, an injection molding method and a slip casting method to produce a ceramic sheet.
According to a dry pressing method or an injection molding method, since the binder amount tends to be large, the shrinkage factor at the time of firing tends to be high, and the dimensional accuracy can not be maintained, whereby it is required to polish the sintered body to prepare a heatsink. A slip casting method is for special shape products with a small lot and is poor in mass productivity, and a thick molded product obtained in this method tends to have an uneven thickness in the width and machine directions.
According to a doctor blade method, it is possible to obtain a molded product having a thickness of from 0.5 to 1 mm, but if the thickness exceeds about 1 mm, the thickness unevenness tends to be significant, and the difference in thickness particularly between at the edge and at the center may be 40 $\mu$m or more in some cases, and a molded product may have significant warpage. Further, a thick product may have a roughened surface or pinholes by an evaporating organic solvent when the organic solvent is dried and removed after sheet molding, and is thereby unsuitable as a heatsink.
On the other hand, according to an extrusion method, a thick sheet can be easily molded only by increasing the clearance of a die, and further, a molding pressure can be increased to from 5 to 10 MPa, whereby it is possible to increase the density of a molded product, and favorable dimensional accuracy at the time of firing will be achieved.
An extrusion molding machine combining a twin screw extruder and a single screw extruder of the present invention is shown in Fig. 1.

A kneading portion of the twin screw extruder usually occupies from 30 to 70 vol% of the twin screw extruder, and the proportion is suitably determined depending upon the specification of the extruder. Here, D represents a screw diameter and L represents a screw length. If the proportion of the kneading portion is less than 30 vol%, the kneading may be insufficient, thus leading to a dispersion of the density of a ceramic sheet in some cases. On the other hand, if it exceeds 70 vol%, excessive kneading may cause remarkable heat generation of a kneaded clay, whereby the fluidity tends to decrease due to the formulation slippage or evaporation of moisture, whereby a sheet with stable quality may not be obtained in some cases. The screw constitution of the twin screw extruder is not particularly limited but is preferably selected considering the kneaded clay being uniformly kneaded.

The kneading portion of the twin screw extruder is suitably determined depending upon the material to be kneaded, the composition, etc., but is preferably constituted by an abrasive resistant material. In general, since a ceramic is hard, screws may be abraded at the time of kneading, thus adversely affecting products in some cases. If the screws or barrels are made of a metal which is likely to be abraded, electrically conductive foreign matters will be included in a product and as a result, insulating properties of the product may decrease in some cases. The abrasive resistant material is not particularly limited, and it may, for example, be SUS440 or a ceramic coating material.

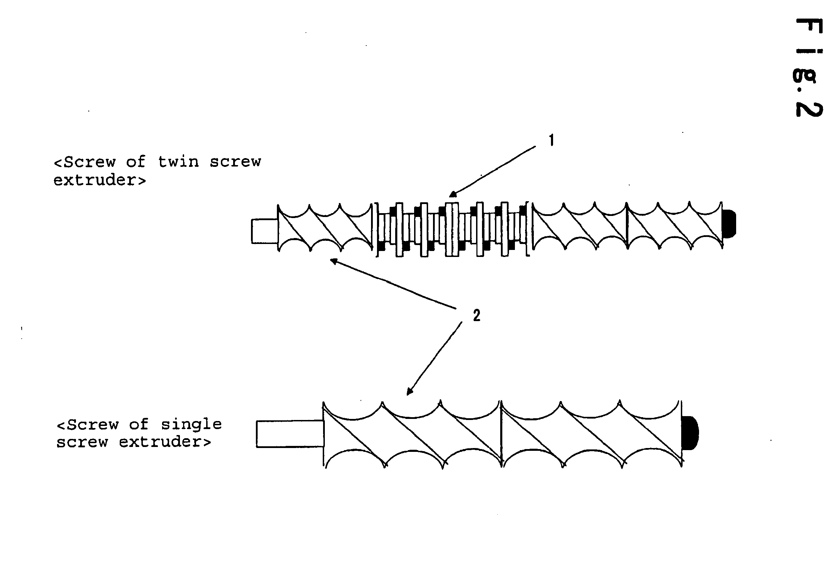

A structure to hold the screw is preferably provided at an intermediate portion and/or the tip of the screw of the twin screw extruder. In general, a twin screw extruder has a structure of holding only the bottom of the screw, but in a case where a hard ceramic clay is kneaded, the tip of the screw and the barrel, or the screws are rubbed with each other and abraded at the time of kneading, and the foreign matters from these members may be included in a product. Accordingly, by providing a holding structure as shown in Fig. 2 at the intermediate portion and/or the tip of the screw, abrasion of the tip of the screw with the barrel or the abrasion of the screws can be suppressed.

The number of revolutions of the screw is suitably determined depending upon the screw structure but is usually from 50 to 200 rpm. If the number of revolutions is less than 50 rpm, no desired discharge amount will be obtained, thus decreasing the productivity in some cases, and if it exceeds 200 rpm, heat generation of the kneaded clay tends to be significant, and the fluidity will decrease due to evaporation of moisture from the binder solution, whereby no stable sheet quality will be obtained in some cases. In order to remove bubbles contained in the kneaded clay by kneading in the twin screw extruder, a vacuum is formed in a portion from the kneading portion to the strand die. On that occasion, a vacuum atmosphere with a degree of vacuum of at most 1,332.2 Pa as represented by absolute pressure is maintained. The twin screw extruder is connected to a chiller unit for cooling, and the temperature of a product discharged from the twin screw extruder is adjusted at from 5 to 15°C.

The twin screw extruder of the present invention is characterized in that (1) a higher shearing strength than that of a single screw extruder can be applied to a gear portion of the screws, whereby a uniformly kneaded clay can be obtained in a short time, and that (2) the screws comprise a plurality of parts and can be reassembled depending upon the material, whereby the degree of freedom in kneading is high, and it is possible to reduce the dispersion of the density in the sheet machine direction and in the sheet width direction. Further, in a case where the kneaded clay is sintered to obtain a ceramic substrate, isotropic shrinkage performance independent of the extrusion direction can be obtained, whereby the dimension failure and deformation of the ceramic substrate can be reduced.

The viscosity at which the components of the kneaded clay are uniform and favorable moldability can be obtained is from 2,000 to 3,000 Pa·sec as measured by a falling flow tester at a shearing strength of 0.3 MPa, and the outline of the sheet cross section is flat. If the viscosity is less than 2,000 Pa·sec, there will be a dispersion of the thickness in the sheet width direction, and the dimensional failure or deformation of the ceramic substrate after firing may occur in some cases. On the other hand, if the viscosity exceeds 3,000 Pa·sec, although the outline of the sheet cross section will be flat, flow marks significantly appear in the machine direction on the sheet surface, whereby the appearance of the ceramic substrate after firing will be impaired in some cases.

The screw diameter D and screw length L of the single screw extruder are not particularly limited, but the screw diameter D of the single screw extruder is preferably at least that of the twin screw extruder. The number of revolutions of the single screw extruder is in proportion with the discharge amount and is thereby preferably from 30 to 100 rpm. If the number of revolutions is less than 30 rpm, no desired discharge amount will be obtained, thus decreasing the productivity. On the other hand, if it exceeds 100 rpm, heat generation of the kneaded clay tends to be significant, and the fluidity will decrease due to evaporation of moisture from the solution, whereby no sheet with stable quality will be obtained in some cases. A kneading portion is not necessary in the single screw extruder as kneading is sufficiently carried out in the twin screw extruder. The single screw extruder is connected to a chiller unit for cooling, and the temperature of a product discharged from the single screw extruder is adjusted at from 5 to 15°C.

A portion at which a discharge outlet of the twin screw extruder and a material feed opening of the single screw extruder are connected is provided as shown in Fig. 1. The box container (vacuum chamber) is a transparent container although its material is not limited, and it is required not to be broken even in a high vacuum. In order to prevent inclusion of bubbles in the surface of the kneaded clay, which may cause a decrease in the density, the atmosphere in the container is maintained at a degree of vacuum of at most 1,332.2 Pa as represented by absolute pressure. For the interface between each of the twin screw extruder and the single screw extruder, and the container, a sealing material such as a resin or rubber packing is used so as to prevent leakage. The kneaded clay discharged from the discharge outlet of the twin screw extruder is carried to the single screw extruder by a kneader provided at the clay feed opening of the single screw extruder immediately below the discharge outlet.

The single screw extruder of the present invention is characterized in that the change in pressure resulting from the material supply system is smaller than that of the twin screw extruder, and that the dispersion of the thickness in the sheet machine direction of the single screw extruder is R ≦ 5 μm, indicating excellent discharge stability, whereas the dispersion of the twin screw extruder is R > 5 μm. If the dispersion of the thickness in the sheet machine direction is R > 5 μm, the amount of warpage of the ceramic substrate after firing in the width direction will be at least 80 μm, and thus a failure may occur in joining to a circuit side metal plate and to a heatsink side metal plate in some cases.

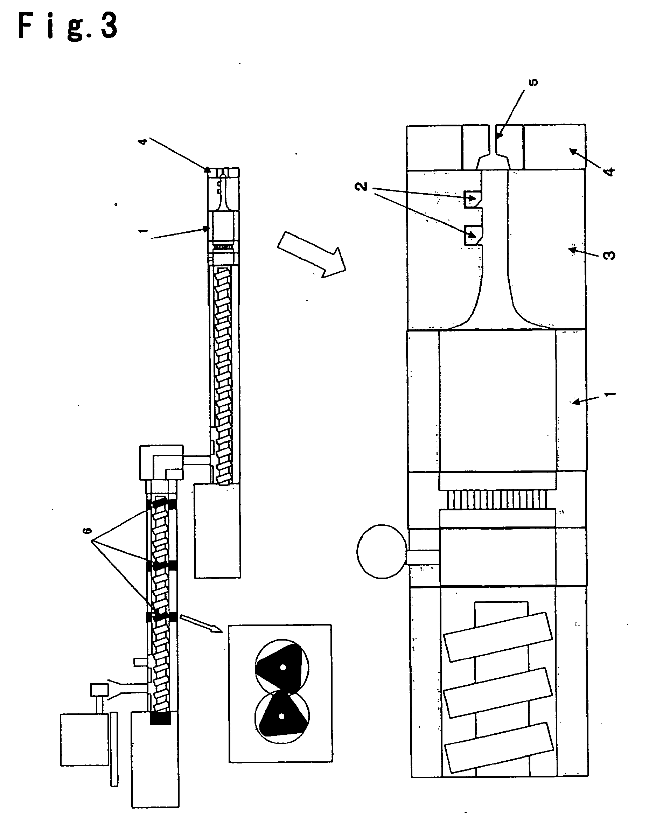

In the single screw extruder of the present invention, a pressure-equalizing can, a die having a flat portion with a length of at least 5 mm at the discharge outlet and baffle boards as shown in Fig. 3 are preferably provided.

The pressure-equalizing can preferably has a length (L) the same as or longer than its diameter (D) (L/D ≧ 1). If the length of the pressure-equalizing can is shorter than the diameter of the can, the thickness of the sheet varies at the discharge outlet due to the influence of the pulsation of the twin screw extruder, and no sheet with a stable thickness will be obtained. Further, the length of the flat portion at the discharge outlet is preferably at least 5 mm. If the length is less than 5 mm, no smooth sheet may be obtained in some cases. Further, it is preferred to provide baffle boards between the pressure-equalizing can and the die at the discharge outlet so as to control the flow of the kneaded clay. By controlling the flow by the baffle boards, a more uniform sheet can be prepared.

The reason of combining a twin screw extruder and a single screw extruder in the present invention is to compensate for drawbacks of these extruders and to make use of their excellent properties. The material feed portion of the twin screw extruder comprises two openings for powder and for liquid as shown in Fig. 1, and it is preferred to carry out powder and liquid supply by means of a weight loss type powder feeder, and to carry out material supply to the liquid feed portion by means of a weight loss type mono-pump or a weight loss type tube pump with small discharge pulsation. What is important is to control the dispersion of powder and liquid feed to be within $|± R\%| ≦ 1$ and to synchronize discharge of a powder feeder and a liquid addition pump. $± R\%$ is calculated from the formulae (1) and (2):

$$R = \max(x_i) - \min(x_i) \qquad \text{Formula (1)}$$

wherein Xi is the discharge amount when measurement is carried out i times.

$$± R\% = \frac{\left( \dfrac{R}{\bar{x_i}} \times 100 \right)}{2} \qquad \text{Formula (2)}$$

wherein
$\bar{x_i}$ is the average of the discharge amount.

If the dispersion is out of $|± R\%| ≦ 1$, the blend proportion of the powder to the liquid will depart from the intended one and the kneaded clay may not have uniform components, thus causing the dispersion of the density of a green sheet, whereby the ceramic substrate after firing may be significantly deformed in some cases.

As the AlN powder of the present invention, a powder produced by a known method such as a direct nitriding method or an alumina reduction method may be used, and it is preferred to use one having an oxygen amount of at most 3 mass% and an average particle size of at most 5μ m, which is subjected to surface treatment with stearic acid, oleic acid, phosphoric acid or the like so as to prevent hydrolysis. Particularly, a surface treatment agent is preferably oleic acid, and its amount of use is preferably from 0.5 to 3 parts by mass per 100 parts by mass of the AlN powder. If it exceeds 3 parts by mass, the fluidity of the kneaded clay may decrease due to the water-repellent effect of oleic acid, thus impairing moldability in some cases.

As the sintering aid of the present invention, it is possible to use a rare earth metal oxide, an alkaline earth oxide, aluminum oxide, a fluoride, a chloride, a nitrate, a sulfate or the like. Particularly, it is common to accelerate sintering of AlN employing a rare earth oxide such as yttrium oxide as the aid, utilizing a liquid phase reaction of the aid with an aluminum oxide as the surface oxide film of the AlN powder. In the present invention, it is more preferred to use aluminum oxide in combination with the rare earth oxide thereby to decrease the firing temperature. The amount of the sintering aid is preferably from 1 to 5 parts by mass per 100 parts by mass of the ceramic powder. If it is less than 1 part by mass or exceeds 5 parts by mass, sintering is less likely to be carried out, and no high density sintered body may be obtained in some cases. The amount of the aluminum oxide is preferably from 1 to 5 parts by mass per 100 parts by mass of the ceramic powder. If it is less than 1 part by mass or exceeds 5 parts by mass, the thermal conductivity of the AlN substrate may decrease in some cases.

The liquid organic binder of the present invention is not particularly limited but is preferably an organic binder containing a polymer obtained by polymerizing one or more members selected from the group consisting of an acrylic acid ester, a methacrylic acid ester, acrylic acid and methacrylic acid. The reason of using such an organic liquid binder is that it has good heat decomposability as compared with another binder, and the carbon residue can easily be controlled in the debindering step in an inert gas atmosphere such as in nitrogen. If the debindering treatment is carried out in an oxidizing atmosphere, the amount of oxygen in the AlN debindered product may increase, and oxygen may be solid-solubilized in the AlN gratings at the time of sintering, thus decreasing the thermal conductivity of the AlN sintered body in some cases. The glass transition temperature of the above polymer is preferably from -50 to 0°C. If the glass transition temperature of the polymer is lower than -50°C, no sufficient strength of the molded product will be obtained, and molding may be difficult in some cases. On the other hand, if the glass transition temperature is higher than 0°C, the melded product tends to be hard and fragile, and it is likely to be broken in some cases.

The proportion of the liquid organic binder added is preferably from 0.5 to 30 mass%, more preferably from 1 to 10 mass% as the outer percentage relative to the ceramic powder. If it is less than 0.5 mass%, no sufficient strength of the molded product will be obtained, and the molded product may be broken in some cases. On the other hand, if it exceeds 30 mass%, the debindering treatment will take very long and further, the amount of the carbon residue in the debindered product tends to be large, whereby the sintered body substrate may have irregular color in some cases.

The organic binder powder of the present invention is not particularly limited, and it is possible to use a methylcellulose type or acrylic type organic binder powder having plasticity and surfactant effects. The amount of the organic binder powder used is preferably from 1 to 5 parts by mass per 100 parts by mass of the ceramic powder. If it is less than 1 part by mass, no sufficient strength of the molded product will be obtained, and the molded product may be broken in some cases. On the other hand, if it exceeds 5 parts by mass, the density of the molded product tends to decrease at the time of binder removal in the debindering step, whereby the shrinkage factor at the time of sintering tends to be high, thus causing dimensional failure or deformation in some cases.

In the present invention, the carbon residue is preferably at most 2.0 mass% after the heat debindering treatment of the molded product. If the carbon residue content exceeds 2.0 mass%, sintering may be inhibited, and no dense sintered body will be obtained in some cases.

As a plasticizer of the present invention, it is possible to use e.g. refined glycerol, glycerin triol or diethylene glycol, and its amount of use is preferably from 2 to 5 parts by mass per 100 parts by mass of the ceramic powder. If it is less than 2 parts by mass, the flexibility of the molded sheet tends to be insufficient, whereby the molded product will be fragile at the time of press-molding, and the sheet is likely to have cracks. On the other hand, if it exceeds 5 parts by mass, the viscosity of the kneaded clay tends to decease, and it will be difficult to hold the sheet shape, whereby the sheet will have a dispersion of the thickness in the sheet width direction in some cases.

The mold release agent in the present invention is not particularly limited, and it is possible to use a stearic acid type or silicon type mold release agent, and its amount of use is preferably from 2 to 5 parts by mass per 100 parts by mass of the ceramic powder. If it is less than 2 parts by mass, the kneaded clay may adhere to a clay feed kneader provided between the twin screw extruder and the single screw extruder, thus impairing the clay feed and decreasing the productivity and further, a dispersion of the sheet thickness resulting from deterioration of the properties of the kneaded clay may occur in some cases. On the other hand, if it exceeds 5 parts by mass, the viscosity of the kneaded clay tends to decrease, and it will be difficult to hold the sheet shape, whereby the dispersion of the thickness in the sheet width direction may occur in some cases.

In the present invention, as the case requires, it is possible to further incorporate a dispersant.

The solvent in the present invention may, for example, be ethanol or toluene, but it is common to use deionized water or pure water considering the global environment and explosion-proof facilities. The amount of use is preferably from 1 to 15 parts by mass per 100 parts by mass of the ceramic powder. If it is less than 1 part by mass, the fluidity of the kneaded clay viscosity tends to be poor, thus impairing sheet molding in some cases. On the other hand, if it exceeds 15 parts by mass, the viscosity of the kneaded clay tends to decrease, and it will be difficult to hold the sheet shape, whereby the dispersion of the thickness in the sheet width direction may occur in some cases.

By use of the molding machine of the present invention, it is possible to make the apparent density of the ceramic sheet be at least 2.5 g/cm$^3$. Accordingly, it is possible to make the shrinkage factor in the AlN sintered body after firing be at most about 12%, whereby the dimensional failure or the deformation failure due to shrinkage at the time of firing can be reduced. If the apparent density of the ceramic sheet is less than 2.5 g/cm$^3$, the shrinkage factor tends to be high, and the dimensional failure and the deformation failure tend to occur.

The strength of the ceramic sheet of the present invention is preferably at least 1.47 MPa. If the sheet strength is less than 1.47 MPa, when a desired shape is punched out from the sheet by a mold, the sheet may be torn, or the sheet may have cracks, thus decreasing the productivity or adversely affecting insulating properties of a product in some cases. The method of treating the sheet thus prepared is not particularly limited, and it is common to carry out heat treatment in a non-oxidizing atmosphere such as in nitrogen gas or in the air or in an oxidizing atmosphere at from 350 to 700°C for from 1 to 10 hours to remove the organic binder (debinder), and put the sheet in a container made of boron nitride, graphite, aluminum nitride or the like and, followed by sintering in a non-oxidizing atmosphere such as in nitrogen, argon, ammonia or hydrogen gas at from 1,450 to 1,800°C.

A metal plate for a metal circuit is joined to one main surface of the ceramic sintered body, and a metal plate for a heatsink is joined to the other main surface, and an etching resist is printed on the circuit face, and on that occasion, positioning is carried out by means of a slide caliper. If there is a drawback in the shape or the dimension in the longitudinal or transverse direction of the ceramic substrate due to the dimensional failure or deformation failure, the printing slippage of the circuit pattern may occur, and in the subsequent module assembling step, the wire bonding providing position may be unsuitable, and electric characteristics may be deteriorated in some cases.

The ceramic sintered body produced by the present invention is excellent in mechanical characteristics and further has high thermal conductivity, and is thereby useful for a circuit board to be used under severe conditions such as a circuit board for a power module. The ceramic circuit board of the present invention is one having a metal circuit formed on one main surface of a substrate employing the ceramic sintered body and a heatsink formed on the other main surface.

The thickness of the ceramic substrate of the preset invention is not particularly limited, and it is usually from about 0.3 to about 1.0 mm when emphasis is put on heat dissipation properties, and from about 1 to about 3 mm when it is desired to remarkably increase the withstanding voltage under high voltage.

With respect to the ceramic sintered body to be produced by the present invention, it is possible to obtain a uniform sintered body free from agglomeration of e.g. the binder, since the kneaded clay is sufficiently kneaded by the twin screw extruder. The proportion of void of the ceramic sintered body is preferably at most 3 vol%. When the proportion of void is low, insulation properties under high voltage tend to be high. Regarding partial discharge characteristics representing the discharge characteristics of the substrate, it is possible to make the 10 pC or higher partial discharge inception voltage of the ceramic circuit board of the present invention be at least 5 kV.

The material of each of the metal circuit and the metal heatsink is preferably Al, Cu or an Al-Cu alloy. They may be used as a single layer or a laminate such as a cladding containing it as one layer. Particularly, Al which has a lower yield at stress than Cu, is likely to undergo plastic deformation, and it can significantly reduce the thermal stress applied to the ceramic substrate when a thermal stress load such as heat cycles is applied. Accordingly, when Al is used, horizontal cracks which are to occur between the metal circuit and the ceramic substrate are less likely to occur as compared with Cu, and it is possible to prepare a more highly reliable module.

The thickness of the metal circuit is not particularly limited, and it is usually from 0.1 to 0.5 mm in the case of an Al circuit and from 0.1 to 0.5 mm in the case of a Cu circuit in view of electrical and thermal specifications. On the other hand, it is required that the heatsink has a thickness with which no warpage will occur at the time of soldering, and for example, the thickness of an Al heatsink is usually from 0.1 to 0.5 mm, and the thickness of a Cu heatsink is usually from 0.1 to 0.5 mm.

The ceramic circuit board of the present invention can be formed by using a plate-shape ceramic sintered body as a substrate or grinding the ceramic sintered body into a plate shape to prepare a substrate, joining a metal plate thereto, and forming a circuit by means of e.g. etching, or by joining a preliminarily formed metal circuit thereto. Joining of the plate-shape ceramic sintered body or a ceramic sintered body formed into a plate-shape by grinding, to the metal circuit, may be carried out by a method of heating them with a solder containing an Al-Cu, Ag, Cu or Ag-Cu alloy and an active metal component such as Ti, Zr or Hf, in an inert gas or vacuum atmosphere (active metal method).

EXAMPLE 1

(Experiments No. 1 to 3)

100 Parts by mass of an AlN powder preliminarily subjected to surface treatment with oleic acid by using a vibrating sieve, 3 parts by mass of an organic binder powder, 2 parts by mass of $Al_2O_3$ and 4 parts by mass of $Y_2O_3$ were dry-mixed in a Bolton mixer, and the mixture was supplied to a powder feed opening of a strongly kneading type molding machine comprising a twin screw extruder and a single screw extruder in combination at 25.8 kg/h by means of a constant rate powder feeder (supply dispersion < 1%). Further, 7 mass% as the outer percentage of an organic liquid binder, 3 parts by mass of a plasticizer, 2 parts by mass of a mold release agent and 4 parts by mass of deionized water per 100 parts by mass of the AlN powder were supplied to a liquid feed opening of the molding machine by means of a constant rate liquid mono-pump (supply dispersion < 1%) at 4.2 kg/h. Of the twin screw extruder, D = 46 mm, L = 1,840 mm (L/D = 40), the kneading portion occupied 70 vol% (D = 46 mm, L = 1,288 mm), the number was revolutions of the screw was 100 rpm and the degree of vacuum was 666.6 Pa as absolute pressure. Further, the degree of vacuum in a vacuum chamber between the twin screw extruder and the single screw extruder was 666.6 Pa. As the single screw extruder, an apparatus having D = 70 mm and L = 700 mm was used, and a strip sheet of 100 mm in width and 1.176 mm in thickness was molded by means of a sheet die under an operation condition at a screw rotational speed of 60 rpm (discharge amount 30 kg/h). The molding conditions are shown in Table 1, and the physical properties of the molded sheet are shown in Table 2.

The green sheet molded by the above machine was dried by a belt dryer and adjusted to dimensions of 70 mm (length) x 50 mm (width) x 1.174 mm (thickness) by a pressing machine provided with a mold. The product was put in a crucible made of boron nitride and held under normal pressure in a nitrogen atmosphere at 600°C for 4 hours for debindering, followed by sintering by a carbon heater electric furnace in a nitrogen atmosphere under an absolute pressure of 0.1 MPa at 1,800°C for 2 hours to prepare an AlN sintered body. The physical properties of the obtained AlN sintered body are shown in Table 3.

(Materials used)

AlN powder: A powder particle diameter D50 of 3.0 $\mu$m, a purity of 99.9%, and impurity contents of 40 ppm with respect to iron and 100 ppm with respect to silicon. For the surface treatment, 1.5 parts by mass of oleic acid was added to 100 parts by mass of the AlN powder.

$Al_2O_3$: "AO-500", trade name, manufactured by Adomatechs Corporation Limited, a powder particle diameter D50 of 1.0 $\mu$m and a purity of 99.9%.

$Y_2O_3$: "Yttrium Oxide" trade name, manufactured by Shin-Etsu Chemical Co., Ltd., a powder particle size D50 of 1.0 $\mu$m and a purity of 99.9%.

Organic liquid binder: "Serander", trade name, manufactured by YUKEN INDUSTRY CO., LTD, main component: an acrylate, a glass transition temperature of -20°C.

Organic binder powder: "CMC DAICEL", trade name, manufactured by DAICEL CHEMICAL INDUSTRIES LTD., main component: carboxymethyl cellulose.

Plasticizer: "EXCEPARL", trade name, manufactured by Kao Corporation, main component: glycerol.

Mold release agent: "Nopcocera LU-6418", trade name, manufactured by SAN NOPCO LIMITED, main component: stearic acid.

Aluminum plate: "1085 material", trade name, manufactured by Mitsubishi Aluminum Company, Ltd. (corresponding JIS No.).

Solder alloy foil: "A2017R-H alloy foil", trade name, manufactured by TOYO SEIHAKU CO., LTD. (corresponding JIS No.).

UV-curable resist ink: "PER-27B-6", trade name, manufactured by GOO CHEMICAL CO., LTD.

Ceramic coating material for twin screw extruder: Alumina.

TABLE 1

| Experiment No. | Material | Volume proportion of kneading portion in twin screw extruder (%) | Discharge amount kg/h | Molding | Material of screw |
|---|---|---|---|---|---|
| 1 | Powder and liquid | 70 | 30 | *1 | Ceramic coating |
| 2 | Powder and liquid | 80 | 30 | *1 | Ceramic coating |
| 3 | Powder and liquid | 30 | 30 | *1 | Ceramic coating |
| 4 | Powder mixture *2 | 70 | 20 | Twin screw extruder alone | Ceramic coating |
| 5 | Powder and liquid | 0 | 30 | Single screw extruder alone | - |
| 6 | Powder mixture *2 | 0 | 30 | Single screw extruder alone | - |
| 7 | Powder and liquid | 70 | 30 | *1 | Ceramic coating |
| 8 | Powder and liquid | 70 | 30 | *1 | Ceramic coating |
| 9 | Powder and liquid | 70 | 30 | *1 | Ceramic coating |
| 10 | Powder and liquid | 70 | 30 | *1 | Ceramic coating |
| 11 | Powder and liquid | 70 | 30 | *1 | SUS440 |
| 12 | Powder and liquid | 70 | 30 | *1 | SS400 |
| 13 | Powder and liquid | 70 | 30 | *1 | Ceramic coating |
| 14 | Powder and liquid | 70 | 30 | *1 | Ceramic coating |
| 15 | Powder and liquid | 70 | 30 | *1 | Ceramic coating |
| 16 | Powder and liquid | 70 | 30 | *1 | Ceramic coating |
| 17 | Powder and liquid | 70 | 30 | *1 | Ceramic coating |
| 18 | Powder and liquid | 70 | 30 | *1 | Ceramic coating |
| 19 | Powder and liquid | 70 | 30 | *1 | Ceramic coating |
| 20 | Powder and liquid | 70 | 30 | *1 | Ceramic coating |

*1: Combination of twin screw extruder and single screw extruder
*2: A material powder, a sintering aid, an organic binder powder, an organic binder liquid, a plasticizer, a mold release agent and deionized water were preliminarily mixed to prepare a wet powder.

TABLE 1 (continued)

| Experiment No. | Screw holding | Degree of vacuum at connection portion (Pa) | Pressure-equalizing can L/D | Length of flat portion of die (mm) | Baffle board | Remarks |
|---|---|---|---|---|---|---|
| 1 | Held | 900 | 2 | 7 | Provided | Example |
| 2 | Held | 900 | 2 | 7 | Provided | Example |
| 3 | Held | 900 | 2 | 7 | Provided | Example |
| 4 | Held | - | - | - | - | Comp. Ex. |
| 5 | - | - | - | - | - | Comp. Ex. |
| 6 | - | - | - | - | - | Comp. Ex. |
| 7 | Held | 900 | 2 | 7 | Provided | Example |
| 8 | Held | 900 | 2 | 7 | Provided | Comp. Ex. |
| 9 | Held | 900 | 2 | 7 | Provided | Example |
| 10 | Held | 900 | 2 | 7 | Provided | Comp. Ex. |
| 11 | Held | 900 | 2 | 7 | Provided | Example |
| 12 | Held | 900 | 2 | 7 | Provided | Example |
| 13 | Nil | 900 | 2 | 7 | Provided | Example |
| 14 | Held | Atmospheric pressure | 2 | 7 | Provided | Example |
| 15 | Held | 1,500 | 2 | 7 | Provided | Example |
| 16 | Held | 900 | 0.8 | 7 | Provided | Example |
| 17 | Held | 900 | 2 | 4 | Provided | Example |
| 18 | Held | 900 | 2 | 7 | Provided | Example |
| 19 | Held | 900 | 2 | 7 | Provided | Example |
| 20 | Held | 900 | 2 | 7 | Nil | Example |

TABLE 2

| Experiment No. | Sheet physical properties | | | | | | |
|---|---|---|---|---|---|---|---|
| | Viscosity of kneaded clay at die portion (Pa·sec) | Sheet thickness (mm) | Dispersion of sheet thickness R ($\mu$m) | Sheet density (g/cm$^3$) | Temperature of discharged product (°C) | Sheet strength (MPa) | Period from material preparation step to formation of sheet (day) |
| 1 | 2,200 | 1.176 | 5 | 2.7 | 12 | 2.35 | 0.5 |
| 2 | 3,500 | 1.176 | 7 | 2.7 | 12 | 2.16 | 0.5 |
| 3 | 3,000 | 1.176 | 5 | 2.6 | 12 | 2.25 | 0.5 |
| 4 | 2,500 | 1.176 | 10 | 2.4 | 12 | 1.96 | 8.0 |
| 5 | 15,000 | 1.176 | 15 | 1.5 | 12 | 1.47 | 0.5 |
| 6 | 5,000 | 1.176 | 10 | 2.0 | 12 | 1.76 | 8.0 |
| 7 | 2,200 | 1.176 | 5 | 2.7 | 12 | 2.35 | 0.5 |
| 8 | 2,200 | 0.5 | 3 | 2.7 | 12 | 1.45 | 0.5 |
| 9 | 2,200 | 5 | 15 | 2.7 | 12 | 2.25 | 0.5 |
| 10 | 2,200 | 15 | 35 | 2.4 | 14 | 2.16 | 0.5 |
| 11 | 2,200 | 1.176 | 5 | 2.7 | 12 | 2.35 | 0.5 |
| 12 | 2,200 | 1.176 | 5 | 2.7 | 12 | 2.35 | 0.5 |
| 13 | 2,200 | 1.176 | 10 | 2.6 | 12 | 2.35 | 0.5 |
| 14 | 2,200 | 1.176 | 5 | 2.5 | 12 | 2.25 | 0.5 |
| 15 | 2,200 | 1.176 | 5 | 2.6 | 12 | 2.35 | 0.5 |
| 16 | 2,200 | 1.176 | 15 | 2.7 | 12 | 2.35 | 0.5 |
| 17 | 2,200 | 1.176 | 5 | 2.7 | 12 | 2.35 | 0.5 |
| 18 | 2,200 | 1.176 | 4 | 2.7 | 5 | 2.35 | 0.5 |
| 19 | 2,200 | 1.176 | 20 | 2.6 | 18 | 2.25 | 0.5 |
| 20 | 2,200 | 1.176 | 20 | 2.7 | 12 | 2.25 | 0.5 |

TABLE 3

| Experiment No. | Sintered body physical properties | | | | |
|---|---|---|---|---|---|
| | Density of sintered body (g/cm³) | Shrinkage factor (%) | Deformation ratio in L direction (%) | Deformation ratio in W direction (%) | Warpage (µm) |
| 1 | 3.3 | 11 | 0.12 | 0.12 | 20 |
| 2 | 3.3 | 11 | 0.12 | 0.12 | 40 |
| 3 | 3.1 | 12 | 0.14 | 0.14 | 40 |
| 4 | 3.1 | 11 | 0.17 | 0.17 | 80 |
| 5 | 2.5 | 16 | 0.20 | 0.20 | 150 |
| 6 | 3.0 | 12 | 0.15 | 0.15 | 40 |
| 7 | 3.3 | 11 | 0.12 | 0.12 | 20 |
| 8 | 3.3 | 11 | 0.12 | 0.12 | 20 |
| 9 | 3.3 | 11 | 0.12 | 0.12 | 20 |
| 10 | 3.2 | 11 | 0.12 | 0.12 | 20 |
| 11 | 3.3 | 11 | 0.12 | 0.12 | 20 |
| 12 | 3.3 | 11 | 0.12 | 0.12 | 20 |
| 13 | 3.3 | 11 | 0.12 | 0.12 | 20 |
| 14 | 3.0 | 12 | 0.15 | 0.15 | 20 |
| 15 | 3.2 | 11 | 0.12 | 0.12 | 20 |
| 16 | 3.3 | 11 | 0.12 | 0.12 | 20 |
| 17 | 3.3 | 11 | 0.12 | 0.12 | 20 |
| 18 | 3.3 | 11 | 0.12 | 0.12 | 20 |
| 19 | 3.2 | 11 | 0.12 | 0.12 | 20 |
| 20 | 3.3 | 11 | 0.12 | 0.12 | 20 |

TABLE 3 (continued)

| Experiment No. | Sintered body physical properties | | | |
| --- | --- | --- | --- | --- |
| | Proportion of void (%) | Thermal conductivity (W/mK) | Deflective strength (MPa) | Partial discharge inception voltage (kV) |
| 1 | 2 | 175 | 500 | 6.8 |
| 2 | 2 | 170 | 450 | 6.6 |
| 3 | 2 | 170 | 450 | 6.6 |
| 4 | 2 | 160 | 400 | 6.0 |
| 5 | 5 | 140 | 280 | 3.2 |
| 6 | 5 | 150 | 350 | 3.4 |
| 7 | 2 | 170 | 500 | 6.8 |
| 8 | 2 | 170 | 500 | 7.0 |
| 9 | 3 | 170 | 450 | 7.8 |
| 10 | 8 | 160 | 400 | 8.9 |
| 11 | 2 | 170 | 500 | 6.2 |
| 12 | 2 | 170 | 500 | 6.0 |
| 13 | 2 | 170 | 500 | 6.0 |
| 14 | 6 | 170 | 250 | 2.8 |
| 15 | 3 | 170 | 400 | 5.0 |
| 16 | 2 | 170 | 450 | 6.6 |
| 17 | 2 | 170 | 500 | 6.4 |
| 18 | 2 | 170 | 500 | 7.2 |
| 19 | 3 | 170 | 400 | 5.1 |
| 20 | 2 | 170 | 500 | 6.6 |

In order to evaluate the performance of the obtained AlN sintered body as a circuit board, aluminum plates as a metal circuit and a metal heatsink were joined by the following method to form a circuit pattern.

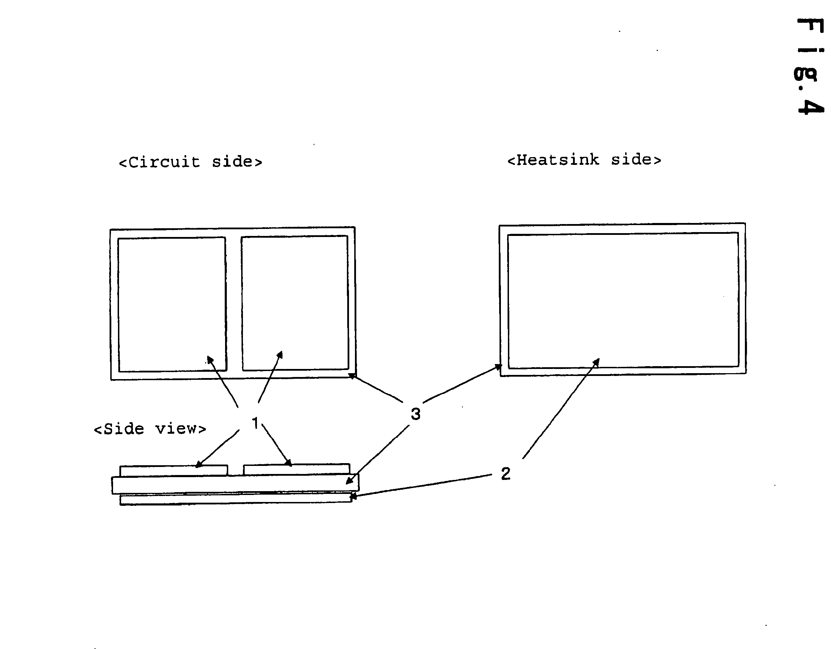

A solder alloy foil of 70 mm x 50 mm x 0.2 mm in thickness was bonded to each side of the AlN sintered body, and the sintered body was sandwiched between aluminum plates of 70 mm x 50 mm x 0.2 mm in thickness, and ten such sandwiches were laminated. The laminate was fixed on a carbon jig by carbon screws and held at 620°C for 2 hours to join the aluminum plates to the AlN sintered body. Screen printing was carried out with a UV curable resist ink so as to form a circuit pattern having a desired shape on one main surface of the assembly and to form a heatsink pattern on the other main surface, followed by irradiation with UV lamp to cure the resist film. Then, a portion other than a portion coated with the resist was etched with a sodium hydroxide aqueous solution, and the resist was removed by an ammonium fluoride aqueous solution to prepare an AlN substrate with an aluminum circuit as shown in Fig. 4.

To evaluate reliability of the obtained circuit board, a thermal history impact test was carried out to confirm 1: presence or absence of pattern printing slippage, 2: presence or absence of occurence of cracks at the connection portion between each of the circuit surface and the heatsink surface and the A1N substrate by observation of the cross section, and 3: presence or absence of occurrence of cracks on the aluminum nitride substrate by means of an ink test after the circuit and heatsink portions were dissolved. The results are shown in Table 3. With respect to the occurrence of cracks at the connection portion, a thermal history impact test was carried out, and a case where cracks occurred after less than 2,000 cycles is represented by the numerical symbol 1, a case where cracks occurred after from 2,000 to 3,000 cycles is represented by the numerical symbol 2, and a case where no cracks occurred even after 3,000 cycles is represented by the numerical symbol 3. The reliability as a circuit board is guaranteed at the numerical symbol 2 or 3. The results are shown in Table 4.

TABLE 4

| Experiment No. | Print pattern slippage | Crack at connection portion | Substrate crack | Remarks |
|---|---|---|---|---|
| 1 | Nil | 3 | Nil | Al circuit board, Al heatsink |
| 2 | Nil | 2 | Nil | Al circuit board, Al heatsink |
| 3 | Nil | 3 | Nil | Al circuit board, Al heatsink |
| 4 | Present | 2 | Nil | Al circuit board, Al heatsink |
| 5 | Present | 1 | Present | Al heatsink board, Al heatsink |
| 6 | Nil | 2 | Present | Al circuit board Al heatsink |
| 7 | Nil | 2 | Nil | Cu circuit board, Cu heatsink |
| 8 | Nil | 3 | Nil | Al circuit board, Al heatsink |
| 9 | Nil | 3 | Nil | Al circuit board, Al heatsink |
| 10 | Nil | 3 | Nil | Al circuit board, Al heatsink |
| 11 | Nil | 3 | Nil | Al circuit board, Al heatsink |
| 12 | Nil | 3 | Nil | Al circuit board, Al heatsink |
| 13 | Nil | 3 | Nil | Al circuit board, Al heatsink |
| 14 | Nil | 2 | Nil | Al circuit board, Al heatsink |
| 15 | Nil | 3 | Nil | Al circuit board, Al heatsink |
| 16 | Nil | 2 | Nil | Al circuit board, Al heatsink |

(continued)

| Experiment No. | Print pattern slippage | Crack at connection portion | Substrate crack | Remarks |
|---|---|---|---|---|
| 17 | Nil | 2 | Nil | Al circuit board, Al heatsink |
| 18 | Nil | 3 | Nil | Al circuit board, Al heatsink |
| 19 | Nil | 2 | Nil | Al circuit board, Al heatsink |
| 20 | Nil | 2 | Nil | Al circuit board, Al heatsink |

(Measurement method)

Thermal history impact test: A test of exposing a test specimen to 3,000 heat cycles, one cycle comprising (-25°C for 10 minutes to room temperature for 10 minutes to 125°C for 10 minutes to room temperature for 10 minutes).

Viscosity of kneaded clay: The viscosity at a shearing strength of 0.3 MPa was measured by a falling flow tester.

Dispersion of sheet thickness R: Using a micrometer, the thickness was measured at intervals of 5 mm from the other edge in the sheet width direction, and the dispersion was obtained from the formula (3):

$$R = \max(y_i) - \min(y_i) \qquad \text{Formula (3)}$$

wherein $y_i$ is the sheet thickness after measurement i times.

Sheet density: Obtained from the formula (4) using a molded product after mold pressing:

$$\rho_{sheet} = \frac{W_{sheet} - W_{liqued}}{l \times w \times t} \qquad \text{Formula (4)}$$

wherein $W_{sheet}$ is the weight of the molded product, $W_{liqued}$ is the weight of the dehydrated molded product after drying at 100°C for 1 hour, 1 is the distance in the sheet longitudinal direction, w is the distance in the transverse direction, and t is the thickness of the molded product.

Shrinkage tactor of sintered body: Obtained from the formula (5):

$$S(\%) = \frac{l_{sheet}}{l_{sintered body}} \times 100 \qquad \text{Formula (5)}$$

wherein S is the shrinkage factor (%) in L direction, $1_{sheet}$ is the length in the longitudinal direction of the molded product, and $1_{sintered\ body}$ is the length in the longitudinal direction of the sintered body.

A breakdown of the period until formation of sheet is shown below. Period required for preparation of a powder and a liquid: 0.5 day, period required for preparation of a mixture of the powder and the liquid: 0.5 day, period required for aging the mixture: 3 days, period required for kneading the mixture: one day, and period required for aging the kneaded product: 3 days.

Shrinkage factors in L direction and W direction of the sintered body: Obtained from the formula (6):

$$l_{yeildedrate}(\%) = \frac{(l_{center} - l_{end})}{l_{center}} \times 100 \quad \text{Formula (6)}$$

wherein $l_{yeilded\,rate}$ is the deformation amount in the longitudinal direction, provided that the + sign represents the center portion in the longitudinal direction longer that the end portion, and the - sign represents the center portion in the longitudinal direction shorter than the end portion, $l_{center}$ is the length of the center portion in the longitudinal direction, and $l_{end}$ is the length in the end portion in the longitudinal direction. The deformation rate in W direction is calculated from the above formula.

Density of sintered body: Calculated from the formula (7) by means of Archimedean method:

$$\rho = \frac{W_1 \rho_E}{(W_2 - W_3)} \quad \text{Formula (7)}$$

wherein r is the bulk density, $W_1$ is the mass of the sintered body in the air, $W_2$ is the mass of the sintered body in the air when through-holes of the sintered body are impregnated with butanol, $W_3$ is the mass of the sintered body in butanol, and $r_E$ is the density of butanol at density measurement (at 25°C) i.e. 0.8048 g/cm$^3$.

Deflective strength of sintered body: Three-point bending test (JIS R1601) was carried out under conditions of a lower span of 30 mm and a cross-head speed of 0.5 mm/min, and the breaking load was obtained from the formula (8) (n = 10):

$$\sigma_f = \frac{3P_f L}{2bh^2} \quad \text{Formula (8)}$$

wherein $\sigma_f$ is the deflective strength, $P_f$ is the breaking load, b is the width of the test specimen, h is the thickness of the test specimen, and L is the lower span length.

Thermal conductivity of sintered body: Carbon spraying treatment was applied to the surface of the AlN substrate, and the thermal conductivity was measured by a laser flash method.

Warpage of sintered body: Measured by a feeler type contour measuring instrument "CONTOURECORD 1600D" manufactured by TOKYO SEIMITSU CO., LTD.

The sheet strength was measured by means of a tensile test method in accordance with JIS K6251 with respect to a sheet with a width of 10 mm and a length of 40 mm.

The proportion of void of the sintered body was obtained in such as manner that the ceramic sintered body was polished to the half of the thickness, and diameters of voids having diameters of at least 15 $\mu$m were measured by an electron microscope, and the proportion of void was obtained from the formula (9) (n = 3).

$$\varepsilon_v = \frac{\sum 4/3 \pi r^3}{At} \times 100 \quad \text{Formula (9)}$$

With respect to the partial discharge inception voltage, the prepared circuit board was immersed in an insulating oil ("Fluorinert FC-77" manufactured by Sumitomo 3M Limited" and a voltage was applied at a rate of 1 kV/min, and the voltage at which the partial discharge charge amount exceeded 10 pC was taken as the partial discharge inception voltage (n = 5).

EXAMPLE 2

(Experiments No. 4 to 6)

The same operation as in Example 1 was carried out except that only one of the twin screw extruder and the single screw extruder was used instead of the strongly kneading type molding machine comprising a twin screw extruder and a single screw extruder in combination. The results are shown in Tables 1 to 4.

EXAMPLE 3

(Experiment No. 7)

The same operation as in Example 1 was carried out except that copper plates were used for the metal circuit and the metal heatsink, and that joining and circuit pattern formation were carried out by the following methods. The results are shown in Tables 1 to 4.

A powder mixture comprising 85 mss% of Ag, 10 mass% of Cu, 2 mass% of Zr and 3 mass% of TiH, and a paste-form liquid mixture comprising 30 mass% of terpineol as outer percentage was applied to both sides of the AlN sintered body, and an oxygen-free copper plate of 3 inches x 2 inches x 0.02 inch in thickness was bonded to both sides, and 14 such sintered bodies were laminated. The laminate was fixed on a carbon jig by means of carbon screws and held at 850°C for 2 hours to prepare an assembly having the AlN sintered body sandwiched between copper plates. Screen printing was carried out with a UV curable resist ink so as to form a circuit pattern having a predetermined shape on one main surface of the assembly and to form a heatsink pattern on the other main surface, followed by irradiation with UV lamp to cure the resist film. Then, a portion other than a portion coated with the resist was etched by a cupric chloride solution, and the resist was removed by an ammonium fluoride aqueous solution to prepare an AlN substrate with a copper circuit.

(Material used)

Oxygen-free copper plate: "Series 3100", trade name, manufactured by Sumitomo Metal Mining Brass & Copper Co., Ltd. (corresponding JIS No.)

EXAMPLE 4

(Experiments No. 8 to 20)

The same operation as in Example 1 except than the sheet thickness, the material of the screws of the twin screw extruder, the structure to hold the screws of the twin screw extruder, the degree of vacuum at a connection portion between the twin screw extruder and the single screw extruder, L/D of the pressure-equalizing can, the length of the flat portion of the die, and presence or absence of baffle boards, were changed. The results are shown in Tables 1 to 4.

In Examples of the present invention, the sheet density is at least 2.5 g/cm$^3$, the shrinkage factor of the AlN sintered body is at most 12%, and the thermal conductivity is at least 170 W/mK, and no cracks at the connection portion nor substrate cracks occurred after the thermal history impact test, whereby it is understood that high reliability as a circuit board will be obtained.

**Claims**

1. A process for producing a ceramic sheet, which comprises molding a ceramic sheet having a thickness of from 1 to 10 mm by using an extrusion molding machine in which a discharge outlet of a twin screw extruder and a material feed opening of a single screw extruder are connected, and which further comprises

   (a) supplying a powder mixture comprising a ceramic powder, a sintering aid and an organic binder powder through a powder feed portion of the twin screw extruder,
   (b) supplying a liquid comprising a liquid organic binder, a mold release agent and a plasticizer through a liquid feed portion of the twin screw extruder,
   (c) kneading the powder mixture and the liquid in a kneading portion in the interior of the twin screw extruder having a kneading portion and a carrier screw portion, and
(d) molding a sheet from the single screw extruder equipped with a sheet die.

2. The process for producing a ceramic sheet according to Claim 1, wherein the connection portion of the discharge outlet of the twin screw extruder and the material feed opening of the single screw extruder is depressurized.

3. The process for producing a ceramic sheet according to Claim 2,
wherein the degree of vacuum at the connection portion of the discharge outlet of the twin screw extruder and the material feed opening of the single screw extruder is at most 1332.2 Pa.

4. The process for producing a ceramic sheet according to any one of Claims 1 to 3, wherein the temperatures of products discharged from the twin screw extruder and the single screw extruder are from 5 to 15 °C.

5. The process for producing a ceramic sheet according to any one of Claims 1 to 4, wherein the kneading portion of the twin screw extruder occupies from 30 to 70 vol% of the twin screw extruder.

6. The process for producing a ceramic sheet according to Claim 5, wherein the kneading portion of the twin screw extruder is made of an abrasive resistant material.

7. The process for producing a ceramic sheet according to any one of Claims 1 to 6, wherein a structure to hold the screw is provided at an intermediate portion and/or the tip of the screw in the twin screw extruder.

8. The process for producing a ceramic sheet according to any one of Claims 1 to 7, wherein a pressure-equalizing can having a length the same as or longer than its diameter is provided in the single screw extruder.

9. The process for producing a ceramic sheet according to any one of Claims 1 to 8, wherein a die having a flat portion with a length of at lest 5 mm is provided at a discharge outlet of the single screw extruder.

10. The process for producing a ceramic sheet according to any one of Claims 1 to 9, wherein a baffle board is provided between the die at the discharge outlet and the pressure-equalizing can in the single screw extruder.

11. The process for producing a ceramic sheet according to Claim 1, wherein the ceramic powder is a nitride ceramic, the sintering aid powder is a rare earth oxide, the organic binder powder is a cellulose or acrylic binder, and the liquid organic binder is an acrylic binder.

12. The process for producing a ceramic sheet according to Claim 11, wherein the nitride ceramic is aluminum nitride, and the sheet has an apparent density of at least 2.5 g/cm$^3$.

13. The process for producing a ceramic sheet according to any one of Claims 1 to 12, wherein the sheet strength is at least 1.47 MPa.

**Patentansprüche**

1. Verfahren zur Herstellung einer Keramikplatte, das ein Formen einer Keramikplatte mit einer Stärke von 1 bis 10 mm unter Verwendung eines Extruders umfasst, bei dem eine Austrittsöffnung eines Doppelschneckenextruders und eine Materialeinlassöffnung eines Einschneckenextruders verbunden sind, und das ferner umfasst:

(a) Zuführen einer Pulvermischung, umfassend ein Keramikpulver, eine Sinterhilfe und ein organisches Bindemittelpulver durch einen Pulvereinlassbereich des Doppelschneckenextruders,
(b) Zuführen einer Flüssigkeit, umfassend ein flüssiges organisches Bindemittel, ein Trennmittei und einen Weichmacher durch einen Flüssigkeitseinlassbereich des Doppelschneckenextruders,
(c) Kneten der Pulvermischung und der Flüssigkeit in einem Knetbereich im Inneren des Doppelschneckenextruders, der einen Knetbereich und einen Transportschneckenbereich aufweist, und
(d) Formen einer Platte mit dem Einschneckenextruder, der mit einer Matritze ausgerüstet ist.

2. Das Verfahren zur Herstellung einer Keramikplatte nach Anspruch 1, wobei der Verbindungsbereich der Austrittsöffnung des Doppelschneckenextruders und der Materialeinlassöffnung des Einschneckenextruders drucklos ist.

**3.** Das Verfahren zur Herstellung einer Keramikplatte nach Anspruch 2, wobei das Vakuum in dem Verbindungsbereich der Austrittsöffnung des Doppelschneckenextruders und der Materialeinlassöffnung des Einschneckenextruders höchstens 1332,2 Pa beträgt.

**4.** Das Verfahren zur Herstellung einer Keramikplatte nach einem der Ansprüche 1 bis 3, wobei die Temperatur von Produkten, die aus dem Doppelschneckenextruder und dem Einschneckenextruder ausgebracht werden, im Bereich von 5 bis 15°C liegt.

**5.** Das Verfahren zur Herstellung einer Keramikplatte nach einem der Ansprüche 1 bis 4, wobei der Knetbereich des Doppelschneckenextruders 30 bis 70 Volumen-% des Doppelschneckenextruders einnimmt.

**6.** Das Verfahren zur Herstellung einer Keramikplatte nach Anspruch 5, wobei der Knetbereich des Doppelschneckenextruders aus einem abriebfesten Material besteht.

**7.** Das Verfahren zur Herstellung einer Keramikplatte nach einem der Ansprüche 1 bis 6, wobei eine Vorrichtung zum Halten der Schnecke in einem Zwischenbereich und/oder der Spitze der Schnecke in dem Doppelschneckenextruder vorgesehen ist.

**8.** Das Verfahren zur Herstellung einer Keramikplatte nach einem der Ansprüche 1 bis 7, wobei ein Druckausgleichsbehälter mit einer Länge, die gleich oder länger ist als der Durchmesser, in dem Einschneckenextruder vorgesehen wird.

**9.** Das Verfahren zur Herstellung einer Keramikplatte nach einem der Ansprüche 1 bis 8, wobei eine Matritze mit einem flachen Bereich mit einer Länge von mindestens 5 mm an einem Auslass des Einschneckenextruders vorgesehen ist.

**10.** Das Verfahren zur Herstellung einer Keramikplatte nach einem der Ansprüche 1 bis 9, wobei ein Schwallblech zwischen der Matritze an der Austrittsöffnung und dem Druckausgleichsbehälter in dem Einschneckenextruder vorgesehen ist.

**11.** Das Verfahren zur Herstellung einer Keramikplatte nach Anspruch 1, wobei das Keramikpulver eine Nitridkeramik ist, das Sinterhilfepulver ein Oxid von Seltenen Erden ist, das Pulver des organischen Bindemittels eine Zelluloseoder Acrylbindemittel ist und das flüssige organische Bindemittel ein Acrylbindemittel ist.

**12.** Das Verfahren zur Herstellung einer Keramikplatte nach Anspruch 11, wobei die Nitridkeramik Aluminumnitrid ist und die Platte eine Dichte von mindestens 2,5 g/cm$^3$ aufweist.

**13.** Das Verfahren zur Herstellung einer Keramikplatte nach einem der Ansprüche 1 bis 12, wobei die Plattenfestigkeit mindestens 1,47 MPa beträgt.

**Revendications**

**1.** Procédé pour produire une feuille de céramique, qui consiste à mouler une feuille de céramique ayant une épaisseur de 1 à 10 mm par utilisation d'une machine de moulage par extrusion dans laquelle un orifice de décharge d'une extrudeuse double vis et une ouverture d'alimentation en matériau d'une extrudeuse simple vis sont connectés, et qui comprend en outre les étapes consistant à :

(a) délivrer un mélange pulvérulent comprenant une poudre de céramique, un auxiliaire de frittage et un liant organique en poudre par l'intermédiaire d'une partie d'alimentation en poudre de l'extrudeuse double vis,
(b) fournir un liquide comprenant un liant organique liquide, un agent de démoulage et un plastifiant par l'intermédiaire d'une partie d'alimentation en liquide de l'extrudeuse double vis,
(c) malaxer le mélange pulvérulent et le liquide dans une partie de malaxage dans l'intérieur de l'extrudeuse double vis ayant une partie de malaxage et une partie de vis de support, et
(d) mouler une feuille à partir de l'extrudeuse simple vis équipée d'une filière à feuille.

**2.** Procédé pour produire une feuille de céramique selon la revendication 1, dans lequel la partie de connexion de l'orifice de décharge de l'extrudeuse double vis et de l'ouverture d'alimentation en matériau de l'extrudeuse simple vis est dépressurisée.

**3.** Procédé pour produire une feuille de céramique selon la revendication 2, dans lequel le degré de vide au niveau de la partie de connexion de l'orifice de décharge de l'extrudeuse double vis et de l'ouverture d'alimentation en matériau de l'extrudeuse simple vis est d'au plus 1332,2 Pa.

**4.** Procédé pour produire une feuille de céramique selon l'une quelconque des revendications 1 à 3, dans lequel les températures des produits déchargés de l'extrudeuse double vis et de l'extrudeuse simple vis vont de 5 à 15°C.

**5.** Procédé pour produire une feuille de céramique selon l'une quelconque des revendications 1 à 4, dans lequel la partie de malaxage de l'extrudeuse double vis occupe 30 à 70 % en volume de l'extrudeuse double vis.

**6.** Procédé pour produire une feuille de céramique selon la revendication 5, dans lequel la partie de malaxage de l'extrudeuse double vis est faite en un matériau résistant abrasif.

**7.** Procédé pour produire une feuille de céramique selon l'une quelconque des revendications 1 à 6, dans lequel une structure pour maintenir la vis est disposée au niveau d'une partie intermédiaire et/ou de la pointe de la vis dans l'extrudeuse double vis.

**8.** Procédé pour produire une feuille de céramique selon l'une quelconque des revendications 1 à 7, dans lequel une bonbonne d'égalisation de pression ayant une longueur égale ou supérieure à son diamètre est disposée dans l'extrudeuse simple vis.

**9.** Procédé pour produire une feuille de céramique selon l'une quelconque des revendications 1 à 8, dans lequel une filière ayant une partie plate avec une longueur d'au moins 5 mm est disposée au niveau d'un orifice de décharge de l'extrudeuse simple vis.

**10.** Procédé pour produire une feuille de céramique selon l'une quelconque des revendications 1 à 9, dans lequel une plaque de retenue est disposée entre la filière au niveau de l'orifice de décharge et la bonbonne d'égalisation de pression dans l'extrudeuse simple vis.

**11.** Procédé pour produire une feuille de céramique selon la revendication 1, dans lequel la poudre de céramique est une céramique de type nitrure, l'auxiliaire de frittage en poudre est un oxyde de terre rare, le liant organique en poudre est un liant cellulosique ou acrylique, et le liant organique liquide est un liant acrylique.

**12.** Procédé pour produire une feuille de céramique selon la revendication 11, dans lequel la céramique de type nitrure est le nitrure d'aluminium, et la feuille a une masse volumique apparente d'au moins 2,5 g/cm$^3$.

**13.** Procédé pour produire une feuille de céramique selon l'une quelconque des revendications 1 à 12, dans lequel la résistance de la feuille est d'au moins 1,47 MPa.

F i g.1

# Fig.2

<Screw of twin screw extruder>

<Screw of single screw extruder>

# Fig.3

Fig. 4

EP 1 726 419 B1

<Circuit side>

<Heatsink side>

<Side view>

1

2

3

**EP 1 726 419 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2083265 A
- JP 11021174 A
- EP 0545056 A